# FASCICULE DE BREVET EUROPEEN

(11) **EP 3 658 595 B1**
(45) Date de publication et mention de la délivrance du brevet: **24.01.2024**
(21) Numéro de dépôt: 18755522.2
(22) Date de dépôt: 17.07.2018
(51) Int. Cl.: C08F 214/20, C08J 5/18, C09D 127/16, C08K 5/00, C08F 214/24

(54) **PROCÉDÉ DE PRÉPARATION D'UN FILM DE POLYMÈRE FLUORÉ RÉTICULÉ**
VERFAHREN ZUR HERSTELLUNG EINES FILMS AUS EINEM VERNETZTEN FLUORPOLYMER
PROCESS FOR THE PREPARATION OF A FILM OF A CROSSLINKED FLUOROPOLYMER

(30) Priorité: 28.07.2017 FR 1757202
(43) Date de publication de la demande: 03.06.2020
(73) Titulaire: Arkema France, 92700 Colombes (FR); Centre National de la Recherche Scientifique, 75016 Paris (FR); Université de Montpellier, 34090 Montpellier (FR); Ecole Nationale Supérieure de Chimie de Montpellier, 34090 Montpellier (FR)
(72) Inventeur: LANNUZEL, Thierry, 69493 PIERRE-BENITE CEDEX (FR); DOMINGUES DOS SANTOS, Fabrice, 75003 Paris (FR); SOULESTIN, Thibaut, 69493 PIERRE-BENITE CEDEX (FR); LADMIRAL, Vincent, 34090 Montpellier (FR); AMEDURI, Bruno, 34000 Montpellier (FR)
(74) Mandataire: Arkema Patent
(86) Numéro de dépôt international: PCT/FR2018/051818
(87) Numéro de publication internationale: WO 2019/020906

(56) Documents cités:
- WO-A1-2015/200872
- US-A1- 2015 116 835
- SHAOBO TAN ET AL: "Significantly improving dielectric and energy storage properties via uniaxially stretching crosslinked P(VDF-co-TrFE) films", JOURNAL OF MATERIALS CHEMISTRY A: MATERIALS FOR ENERGY AND SUSTAINABILITY, vol. 1, no. 35, 1 janvier 2013 (2013-01-01), page 10353, XP055429969, GB ISSN: 2050-7488, DOI: 10.1039/c3ta11484h cité dans la demande
- SHAOBO TAN ET AL: "Synthesis of fluoropolymer containing tunable unsaturation by a controlled dehydrochlorination of P(VDF-co-CTFE) and its curing for high performance rubber applications", JOURNAL OF MATERIALS CHEMISTRY, ROYAL SOCIETY OF CHEMISTRY, GB, vol. 22, no. 35, 21 septembre 2012 (2012-09-21), pages 18496-18504, XP002731229, ISSN: 0959-9428, DOI: 10.1039/C2JM33133K [extrait le 2012-07-25] cité dans la demande

## Description

### DOMAINE DE L'INVENTION

La présente invention concerne un procédé de préparation d'un film de polymère fluoré réticulé. Elle concerne également le film susceptible d'être obtenu suivant ce procédé, ainsi que ses utilisations, notamment dans la fabrication de dispositifs (opto)électroniques et plus particulièrement comme couche diélectrique de grille dans un transistor à effet de champ.

### ARRIERE-PLAN TECHNIQUE

Les polymères fluorés à base de fluorure de vinylidène (VDF) représentent une classe de composés ayant des propriétés remarquables pour un grand nombre d'applications. Le PVDF et les copolymères comprenant du VDF et du trifluoroéthylène (TrFE) sont particulièrement intéressants en raison de leurs propriétés ferro-, piezo- et pyroélectriques. Ces matériaux, polymères fluorés électroactifs, ou PFEAs, possèdent une polarisation spontanée à basse température, qui peut être renversée par application d'un champ électrique externe. La variation de leur polarisation en fonction du champ n'est pas linéaire et, si le champ électrique est alternatif, la polarisation décrit un cycle d'hystérésis caractérisé par la polarisation rémanente et le champ coercitif (champ électrique appliqué nécessaire à l'annulation de la polarisation). Au-delà d'une température de transition, les matériaux ferroélectriques présentent un comportement proche d'un matériau diélectrique linéaire, séparant l'état ferroélectrique d'un état paraélectrique.

Parmi les matériaux ferroélectriques, il est possible de distinguer, suivant les caractéristiques de leur transition mais aussi par leur comportement en fréquence, les matériaux ferroélectriques classiques et les matériaux ferroélectriques relaxeurs. Précisément, les matériaux ferroélectriques classiques présentent un maximum étroit de leur constante diélectrique à la température de Curie Tc où se produit la transition ferroélectrique - paraélectrique. La valeur de Tc est en outre indépendante de la fréquence. Au contraire, les matériaux ferroélectriques relaxeurs présentent une courbe de permittivité diélectrique (appelée aussi constante diélectrique) en fonction de la température comportant un pic de transition diffuse s'étendant sur une gamme de températures relativement large, T_{C'}, où se produit la transition relaxeur ferroélectique - paraélectrique. En outre, le maximum de constante diélectrique se trouve déplacé vers des températures supérieures lorsque la fréquence augmente.

Il est connu que l'utilisation d'un tiers monomère portant un substituant encombrant, tel que le chlorofluoroéthylène (CFE) ou le chlorotrifluoroéthylène (CTFE) permet de modifier la cristallisation des polymères ferroélectriques à base de VDF et de TrFE, de sorte à leur conférer des propriétés de matériaux relaxeurs avec des effets électrostrictifs importants et une meilleure permittivité diélectrique.

Toutefois, ces polymères ferroélectriques et relaxeurs ferroélectriques doivent être réticulés pour améliorer leurs propriétés électroniques et mécaniques, notamment leur constante diélectrique, en vue de leur incorporation dans certains dispositifs tels que des transistors. La réticulation confère également à ces polymères une résistance aux solvants, permettant de les utiliser dans des procédés de photolithographie. Il est en particulier souhaitable qu'ils puissent être photo-réticulés, notamment pour permettre la réalisation de motifs (« patterning ») à partir d'une couche ou film du polymère, et afin d'éviter les problèmes inhérents aux films obtenus par réticulation thermique.

Il a déjà été suggéré dans la demande WO 2015/200872 un procédé de photoréticulation de polymères fluorés, tels qu'un terpolymère (VDF-ter-TrFE-ter-CFE), comprenant la formulation d'une encre contenant ce copolymère, une base non nucléophile, telle qu'une amine tertiaire de structure polycyclique ou hétéroaromatique, et un agent de réticulation. Cette encre est déposée sur un substrat pour former un film qui est ensuite exposé aux UV, de sorte que la base provoque une déshydrohalogénation du copolymère. Une double liaison est ainsi formée dans la structure du copolymère, et de l'acide chlorhydrique est libéré. Cette double liaison peut être ensuite réticulée par l'agent réticulant. Dans ce procédé, l'encombrement stérique généré par l'amine permet d'éviter la réaction de l'amine avec les atomes de fluor présents dans le copolymère et de conduire ainsi à la formation concomitante de fluorure d'hydrogène.

Il est apparu à la Demanderesse qu'une base particulière, ayant un faible encombrement stérique, à savoir la triéthylamine, pouvait être substituée aux amines tertiaires de WO 2015/200872 sans affecter sensiblement les propriétés électroniques, thermiques et/ou chimiques du film réticulé obtenu, voire en améliorant certaines au moins de ces propriétés.

La triéthylamine a déjà été utilisée dans des réactions de déshydrochloration de co- ou terpolymères du type poly(VDF-ter-TrFE-ter-CTFE) (J. Mater. Chem., 2013, 1, 10353-10361) et du type poly(VDF-co-CTFE) (J. Mater. Chem., 2012, 22, 18496-18504). Les copolymères décrits dans la seconde publication ne présentent toutefois pas de propriétés de relaxeur ferroélectrique en raison de l'absence de monomère trifluoroéthylène. En outre, dans ces deux publications, les matériaux résultants sont réticulés à l'aide de peroxydes thermiques. Ces peroxydes, souvent utilisés à des températures élevées (supérieures à 100 °C) ne permettent pas la réalisation de motifs à température ambiante. Ces procédés ne sont donc pas adaptés à la fabrication de dispositifs électroniques.

### RESUME DE L'INVENTION

L'invention a pour objet un procédé de préparation de films de polymères fluorés réticulés, comprenant les étapes successives de :
(1) formulation d'une encre contenant, de préférence constituée de : le produit de la réaction de la triéthylamine avec au moins un copolymère fluoré obtenu par copolymérisation radicalaire de monomères comprenant, et de préférence constitués par : (i) le fluorure de vinylidène (VDF), (ii) le trifluoroéthylène (TrFE), (iii) au moins un monomère chloré de formule -CXCl=CX₁X₂ où X, X₁ et X₂ désignent indépendamment H, F ou CF₃, étant entendu qu'au plus l'un de X, X₁ et X₂ désigne CF₃ ; (b) au moins un agent réticulant ; (c) au moins un photo-amorceur ; et (d) au moins un solvant organique ;
(2) l'application de ladite encre sous forme de film sur un substrat ; et
(3) l'irradiation UV dudit film.

L'invention a également pour objet un film de polymère fluoré réticulé susceptible d'être obtenu suivant ce procédé, ainsi que l'utilisation de ce film pour la fabrication de dispositifs (opto)électroniques, y compris des transistors à films fins, des transistors lumineux, des transistors à effet de champ et des condensateurs ; de dispositifs haptiques ; d'actionneurs ; de microsystèmes électromécaniques (MEMS) ; de capteurs ; de cathéters orientables ; de claviers braille ; de dispositifs acoustiques (hauts parleurs ou « tweeters ») ; de dispositifs électrocaloriques ; de dispositifs de récupération d'énergie, de préférence dans la fabrication de transistors.

Il a été observé que le procédé selon l'invention permettait d'obtenir un matériau semicristallin électroactif ayant une haute résistance aux solvants, un faible champ coercitif, une permittivité électrique élevée et/ou une polarisation à saturation élevée.

### FIGURES

La **Figure 1** représente le spectre FTIR des produits P1 (ligne pleine), P3 (ligne brisée) et P2 (ligne brisée-points), préparés selon l'Exemple 1, où l'axe des abscisses correspond au nombre d'onde en cm⁻¹ et l'axe des ordonnées à l'absorbance relative.
La **Figure 2** représente le thermogramme de l'analyse par calorimétrie différentielle à balayage lors de la deuxième montée en température entre -50 et 200 °C du produit P2 préparé selon l'Exemple 1, où l'axe des abscisses correspond à la température en °C et la température de fusion est mesurée au sommet du second pic endothermique à 120 °C.
La **Figure 3** illustre la courbe de polarisation du produit P1 préparé selon l'Exemple 1, où l'axe des abscisses correspond au champ électrique en MV.m⁻¹ et l'axe des ordonnées au déplacement en mc.m⁻².
La **Figure 4** représente la courbe de polarisation du produit P2 préparé selon l'Exemple 1, où l'axe des abscisses correspond au champ électrique en MV.m⁻¹ et l'axe des ordonnées au déplacement en mC.m⁻².

### DESCRIPTION DE MODES DE REALISATION DE L'INVENTION

Comme indiqué précédemment, la présente invention porte sur un procédé de préparation d'un film à partir d'une encre renfermant un copolymère fluoré électroactif.

Le copolymère fluoré utilisé dans cette invention comprend un motif issu du fluorure de vinylidène (VDF) et un motif issu du trifluoroéthylène (TrFE). Il renferme en outre au moins un monomère chloré de formule-CXCl=CX₁X₂ où X, X₁ et X₂ désignent indépendamment H, F ou CF₃, étant entendu qu'au plus l'un de X, X₁ et X₂ désigne CF₃. Des exemples de tels monomères chlorés sont notamment le chlorofluoroéthylène (CFE), le chlorotrifluoréthylène (CTFE), le 2-chloro-3,3,3-trifluoropropène, le 1-chloro-3,3,3-trifluoropropène, de préférence le CTFE et le CFE. Ce copolymère peut en outre renfermer au moins un autre motif issu d'un monomère fluoré, qui peut notamment être choisi parmi : le tétrafluoroéthylène (TFE), l'hexafluoropropylène (HFP), le 2-(trifluorométhyl) acide acrylique, le trifluoropropène, le tétrafluoropropène, l'hexafluoroisobutylène, le perfluorobutyléthylène, le pentafluoropropène, les perfluoroalkyléthers tels que le PMVE, le PEVE et le PPVE, et leurs mélanges. Il est bien entendu que tous les isomères géométriques des composés fluorés précités sont inclus dans les terminologies ci-dessus, tels que le 3,3,3-trifluoropropène, le 2,3,3,3-tétrafluoropropène (ou 1234yf), le 3-chloro-2,3,3-trifluoropropène (ou 1233yf). En outre, on préfère que le copolymère selon l'invention ne renferme pas de motif issu d'un monomère non fluoré*)*. Selon une forme d'exécution de l'invention, le copolymère fluoré est un terpolymère ne renfermant que des unités issues du VDF, du TrFE et du monomère chloré.

Selon un mode de réalisation, la proportion de motifs issus du TrFE est de préférence de 5 à 95 mol.% par rapport à la somme des motifs issus du VDF et du TrFE, et notamment : de 5 à 10 mol.% ; ou de 10 à 15 mol.% ; ou de 15 à 20 mol.% ; ou de 20 à 25 mol.% ; ou de 25 à 30 mol.% ; ou de 30 à 35 mol.% ; ou de 35 à 40 mol.% ; ou de 40 à 45 mol.% ; ou de 45 à 50 mol.% ; ou de 50 à 55 mol.% ; ou de 55 à 60 mol.% ; ou de 60 à 65 mol.% ; ou de 65 à 70 mol.% ; ou de 70 à 75 mol.% ; ou de 75 à 80 mol.% ; ou de 80 à 85 mol.% ; ou de 85 à 90 mol.% ; ou de 90 à 95 mol.%. Une gamme de 15 à 55 mol.% est particulièrement préférée.

La proportion de motifs issus du monomère chloré (par rapport à la totalité des motifs) peut varier par exemple de 1 à 20 mol.%, en particulier de 5 à 15 mol.%.

De leur côté, les motifs issus du monomère additionnel éventuellement présent peuvent représenter de 0 à 20 mol.% et de préférence de 5 à 15 mol.%, par rapport à la totalité des motifs.

Les copolymères utilisés selon l'invention sont avantageusement statistiques et linéaires.

Les copolymères utilisés selon l'invention sont préparés par polymérisation radicalaire selon un procédé de polymérisation en solution, en suspension, en émulsion, ou en micro-émulsion.

La réaction de copolymérisation est généralement effectuée en présence d'un amorceur radicalaire. Celui-ci peut être par exemple un t-alkyl peroxyester tel que le peroxypivalate de *tert*-butyle (ou TBPPI), le peroxypivalate de *tert*-amyle, un peroxydicarbonate tel que le peroxydicarbonate de bis(4-*tert*-butyl cyclohexyle), le persulfate de sodium, d'ammonium ou de potassium, le peroxyde de benzoyle et ses dérivés, un *tert*-alkyl hydroperoxyde tel que l'hydroxyperoxyde de *tert*-butyle, un t-alkyl peroxyde tel que le peroxyde de *tert*-butyle ou un t-alkyl-peroxyalcane tel que le 2,5-bis(*tert*-butylperoxy)-2,5-diméthylhexane. En variante ou en plus, on peut utiliser comme amorceur radicalaire un amorceur azo ou un système redox.

Selon un premier mode de réalisation, le copolymère utilisé selon l'invention est préparé par un procédé de polymérisation radicalaire en solution, tel que celui décrit notamment dans la demande de brevet WO 2014/162080, comprenant une étape de copolymérisation d'un mélange réactionnel de monomères fluorés et de monomère chloré en présence d'un amorceur radicalaire dans un solvant.

Selon un mode de réalisation particulier :
- la proportion de TrFE dans le mélange réactionnel est de préférence de 5 à 95 mol.% par rapport à la somme des monomères VDF et TrFE, et notamment : de 5 à 10 mol.% ; ou de 10 à 15 mol.% ; ou de 15 à 20 mol.% ; ou de 20 à 25 mol.% ; ou de 25 à 30 mol.% ; ou de 30 à 35 mol.% ; ou de 35 à 40 mol.% ; ou de 40 à 45 mol.% ; ou de 45 à 50 mol.% ; ou de 50 à 55 mol.% ; ou de 55 à 60 mol.% ; ou de 60 à 65 mol.% ; ou de 65 à 70 mol.% ; ou de 70 à 75 mol.% ; ou de 75 à 80 mol.% ; ou de 80 à 85 mol.% ; ou de 85 à 90 mol.% ; ou de 90 à 95 mol.%, une gamme de 15 à 55 mol.% étant particulièrement préférée ;

- la proportion de monomère chloré dans le mélange réactionnel peut varier par exemple de 1 à 20 mol.%, en particulier de 5 à 15 mol.% ; et
- la proportion de monomère additionnel éventuellement présent dans le mélange réactionnel peut représenter de 0 à 20 mol.% et de préférence de 5 à 15 mol.%,
les pourcentages ci-dessus étant exprimés par rapport à la totalité des monomères présents dans le mélange réactionnel, dont la somme est égale à 100%.

Selon un mode de réalisation, le mélange réactionnel consiste essentiellement en, et de préférence consiste en, un mélange de fluorure de vinylidène, de trifluoroéthylène, de monomère chloré, d'amorceur radicalaire, et de solvant. Par « consiste essentiellement », on entend qu'il renferme au moins 70% molaire, plus préférentiellement au moins 80% molaire, par exemple au moins 90% molaire, voire au moins 95% molaire, de ces constituants.

La réaction est effectuée dans un solvant, qui est par exemple choisi parmi un solvant organique tel que le 1,1,1,3,3-pentafluorobutane, le 2,2,2-trifluoroéthanol, l'hexafluoroisopropanol; le 1,1,2-trifluorotrichloroéthane ; le diméthylformamide ; le diméthylacétamide ; le diméthylsulfoxyde ; les cétones, notamment l'acétone, la méthyléthylcétone, la méthylisobutylcétone et la cyclopentanone ; les furanes, notamment le tétrahydrofurane ; les esters, notamment l'acétate de méthyle, l'acétate d'éthyle, l'acétate de propyle, l'acétate de butyle et l'acétate de propylène glycol méthyl éther ; les carbonates, notamment le diméthylcarbonate ; les phosphates, notamment le triéthylphosphate ; l'eau et les mélanges de ceux-ci.

Selon un mode de réalisation, le mélange réactionnel est chauffé jusqu'à une température de démarrage de réaction comprise entre 20 et 100°C et de préférence entre 25 et 80°C. La pression initiale à l'intérieur de l'autoclave varie en fonction du solvant, de la température de la réaction et de la quantité de monomères. Elle est généralement comprise entre 0 à 80 bars, par exemple entre 20 et 40 bars. Le choix de la température optimale dépend de l'amorceur qui est utilisé. Généralement, la réaction est mise en oeuvre pendant une durée de deux à quatre fois le temps de demi-vie de l'amorceur utilisé, par exemple de 6 heures à 25 h, à une température à laquelle le temps de demi-vie de l'amorceur est compris entre 1 et 10 heures.

La masse molaire du copolymère obtenu par polymérisation en solution est de préférence de 5 000 à 200 000 g/mol, plus préférentiellement de 10 000 à 150 000 g/mol.

Selon un autre mode de réalisation, le copolymère utilisé selon l'invention est préparé par un procédé de polymérisation radicalaire en suspension, tel que celui décrit notamment dans la demande de brevet WO 2010/116105, comprenant une étape de copolymérisation d'un mélange réactionnel des monomères en présence d'eau, d'un amorceur radicalaire, éventuellement d'un agent de dispersion et, éventuellement, d'un agent de transfert de chaîne.

Le procédé en suspension permet d'éviter l'utilisation de solvants toxiques et de tensioactifs fluorés (type PFOA ou PFOS bioaccumumables, toxiques et persistants) lors de la synthèse et de la purification du copolymère.

Dans le procédé en suspension, les monomères sont chargés dans un réacteur agité contenant de l'eau déionisée, éventuellement un agent de dispersion et, éventuellement, un agent de transfert de chaîne.

Le réacteur est ensuite porté à la température d'amorçage souhaitée, cette température étant maintenue pendant la polymérisation à une valeur comprise entre 40 et 60°C. L'amorceur est ensuite injecté dans le réacteur pour démarrer la polymérisation. La consommation des monomères conduit à une diminution de pression qui est généralement maintenue dans la plage de 80 à 110 bars par injection d'eau déionisée ou d'un mélange de monomères. Le réacteur est ensuite refroidi et dégazé. Le produit est déchargé et récupéré sous la forme d'une suspension. Cette suspension est filtrée et la poudre humide est lavée puis séchée.

Selon encore un autre mode de réalisation, le copolymère utilisé selon l'invention est préparé suivant un procédé de polymérisation radicalaire en émulsion.

Pour ce faire, on prépare avantageusement une dispersion aqueuse de l'amorceur stabilisé par le tensioactif utilisé pour conduire la polymérisation. On préfère ne pas utiliser de tensioactif perfluoré. Pour réaliser cette dispersion, on mélange l'eau, l'amorceur et une faible fraction de la totalité du tensioactif dans un disperseur. C'est cette dispersion qui est ajoutée au début puis éventuellement au cours de la polymérisation. Après chargement du réacteur de polymérisation avec de l'eau, du tensioactif et éventuellement de la paraffine, on pressurise le réacteur, après avoir éliminé l'oxygène, en y ajoutant du fluorure de vinylidène seul ou en mélange avec les comonomères et on porte à la température choisie. Avantageusement, l'émulsion aqueuse est polymérisée à une température de 50 à 130°C. De préférence, la polymérisation est réalisée à une pression absolue de 40 à 120 bars. Le démarrage de la réaction est obtenu par addition de la dispersion d'amorceur. Pendant la polymérisation, on ajoute éventuellement le VDF seul ou en mélange avec les comonomères pour maintenir la pression ou pour obtenir une variation de pression contrôlée. On procède éventuellement à l'addition de l'amorceur par incréments ou en continu. Un agent de transfert de chaîne (CTA) peut éventuellement être ajouté au début ou au cours de la polymérisation. Dans ce dernier cas, il peut être introduit par incréments ou en continu. Après introduction de la quantité prévue de mélange de monomères, le réacteur est dégazé et refroidi et le latex est vidangé.

La récupération du polymère à partir du latex constitue l'opération de finition. Celle-ci consiste essentiellement à coaguler le latex puis à sécher le coagulat pour obtenir une poudre sèche. La finition peut également inclure une étape de lavage. Ce lavage peut, par exemple, être réalisé par introduction du latex, éventuellement dilué, dans un coagulateur où il est soumis à un cisaillement en présence d'air. Sous l'effet cumulé de ces deux actions, le latex se transforme en crème aérée d'une densité inférieure à celle de l'eau. Cette crème est éventuellement lavée à contre-courant avec de l'eau déionisée, par exemple selon le procédé décrit dans les brevets US 4,128,517 et EP 0 460 284. Le séchage peut être réalisé selon tout moyen industriel connu de l'homme de l'art. En particulier, on peut avantageusement sécher le latex coagulé ou la crème dans un atomiseur. Ainsi, à la sortie de la colonne de lavage ou immédiatement après la coagulation, la crème aérée est envoyée dans un récipient de stockage avant d'être dirigée par pompage dans un atomiseur qui la transforme en une poudre sèche. Cette étape de séchage dans un atomiseur peut également être appliquée au latex initial, éventuellement dilué, au latex coagulé (par exemple par cisaillement mécanique avec ou sans dilution préalable) ou encore à la crème aérée.

Un autre procédé de polymérisation en émulsion utilisable pour préparer le copolymère utilisé selon l'invention est celui décrit dans le document US-7,122,608. Le copolymère selon l'invention est mis à réagir avec la triéthylamine et formulé sous la forme d'une encre photo-réticulable comprenant au moins un agent réticulant, au moins un photo-amorceur et au moins un solvant organique.

Comme indiqué précédemment, la triéthylamine permet de déshydrochlorer le copolymère, c'est-à-dire d'éliminer une molécule de HCl à partir de chaque motif CFCl-CH₂ avec lequel elle est susceptible de réagir. Ces motifs peuvent provenir par exemple d'un monomère CFE ou d'un dimère VDF-CTFE. Des doubles liaisons sont ainsi créées dans le copolymère, qui peuvent ensuite réagir avec l'agent réticulant pour le réticuler. De manière avantageuse, le procédé selon l'invention ne génère sensiblement pas d'acide fluorhydrique (HF).

La proportion de triéthylamine est de préférence ajustée de manière à conserver des motifs -CFCl-CH₂- au sein du copolymère à l'issue du procédé.

La triéthylamine peut ainsi représenter de 0,1 à 2 équivalents molaires par rapport au nombre de moles de monomère chloré, de préférence de 0,2 à 1,5 équivalent molaire.

Dans une première forme d'exécution de l'invention, la réaction entre le copolymère décrit précédemment et la triéthylamine est réalisée *in situ* au sein de l'encre dans laquelle ces deux composés sont formulés. L'encre selon l'invention renferme donc ce copolymère et la triéthylamine, en plus de l'agent réticulant, du photo-amorceur et du solvant organique. Dans une seconde forme d'exécution de l'invention, le copolymère est mis à réagir avec la triéthylamine avant d'être mélangé aux autres constituants de l'encre. L'encre selon l'invention est donc obtenue par mélange du produit de cette réaction avec l'agent réticulant, le photo-amorceur et le solvant organique. En d'autres termes, le procédé selon l'invention comprend une étape préliminaire consistant à faire réagir le copolymère décrit précédemment avec la triéthylamine, généralement dans un solvant organique qui peut notamment être choisi parmi ceux listés ci-après comme constituants de l'encre. Cette réaction peut par exemple être conduite pendant une durée de 1 à 10 heures, notamment de 2 à 6 heures, à une température allant par exemple de 20 à 80°C et de préférence de 30 à 60°C. Le produit de cette réaction est généralement purifié et séché avant d'être mis en oeuvre dans le procédé selon l'invention.

Comme indiqué précédemment, l'encre utilisée selon l'invention comprend également au moins un agent réticulant et au moins un photo-amorceur.

L'agent réticulant peut être tout composé capable de réagir avec des doubles liaisons, notamment une petite molécule ou un polymère ou pré-polymère porteurs soit d'un ou plusieurs groupes thiol capables de réagir avec les doubles liaisons par chimie clic thiol-ène, soit d'un ou plusieurs groupes amine capables de réagir avec les doubles liaisons par hydroamination, soit d'un ou plusieurs groupes maléimide capables de réagir avec les doubles liaisons par conjugaison. En variante, l'agent réticulant peut être une petite molécule ou un polymère ou pré-polymère porteurs d'un ou plusieurs groupes vinyliques. Il est bien entendu que les exemples ci-dessus ne sont pas limitatifs et qu'il est en outre possible d'utiliser un agent réticulant porteur de plusieurs des groupes réactifs précités ou plusieurs agents réticulants porteurs de groupes réactifs différents. Des exemples de tels agents réticulants comprennent notamment le poly(3-mercaptopropyl)méthylsiloxane, le maléimide siloxane, le pentaérythritol tétrakis(3-mercaptopropionate), la triméthyléthylènediamine, le 1,2-diamino-4,5-difluorobenzène et le butane-1,4-trans-cinnamate, sans que cette liste ne soit limitative.

Les agents réticulants préférés pour une utilisation dans la présente invention sont des monomères ou oligomères portant au moins deux fonctions (méth)acryliques réactives en polymérisation radicalaire, qui peuvent éventuellement comprendre en outre au moins une autre fonction choisie parmi des fonctions hydroxyles, esters, éthers, uréthanes, époxy, cyanurates ou iso-cyanurates. On peut ainsi citer, par exemple, les composés suivants : 1,3-butylène glycol di(méth)acrylate, butanediol di(méth)acrylate, 1,6-hexanediol di(méth)acrylate, hexanediol alkoxylé di(méth)acrylate, néopentyl glycol alkoxylé di(méth)acrylate, dodécyl di(méth) acrylate, cyclohexane diméthanol di(méth)acrylate, diéthylène glycol di(méth)acrylate, dipropylène glycol di(méth)acrylate, les alcanes linéaires di(méth) acrylate, bisphénol A éthoxylé di(méth)acrylate, éthylène glycol di(méth)acrylate, néopentyl glycol di(méth)acrylate, tricyclodécane diméthanol diacrylate, triéthylène glycol di(méth)acrylate, tétraéthylène glycol di(méth)acrylate, tripropylène glycol di(méth)acrylate, ditriméthylolpropane tétra(méth)acrylate, pentaérythritol éthoxylé tétra(méth)acrylate, dipentaérythritol penta(méth)acrylate, penta(méth)acrylate ester, pentaérythritol tétra(méth)acrylate, triméthylolpropane éthoxylé tri(méth)acrylate, triméthylolpropane alkoxylé tri(méth)acrylate, triméthylolpropane tri(méth)acrylate, pentaérythritol tri(méth)acrylate, triméthylolpropane propoxylé tri(méth)acrylate, triméthylolpropane triméthacrylate, dodécanediol di(méth)acrylate, dodécane di(méth)acrylate, dipentaérythritol penta/hexa(méth)acrylate, pentaérythritol tetra(méth)acrylate, di-triméthylolpropane tétra(méth)acrylate, glyceryl propoxylé tri(méth)acrylate, glycéryl propoxylé tri(méth)acrylate, tris (2-hydroxy éthyl) isocyanurate tri(méth)acrylate, polyesters (méth)acrylates, polyéthers (méth)acrylates, polyéthylènes glycol (méth)acrylates, polypropylènes glycol (méth)acrylates, polyuréthanes (méth)acrylates, epoxy (méth)acrylates, et les combinaisons de ceux-ci.

L'agent réticulant peut représenter de 1 à 20% et de préférence de 3 à 10% en moles, par rapport au nombre de moles de copolymère.

Des exemples de photo-amorceurs utilisables dans l'encre utilisée selon l'invention comprennent : le 2-hydroxy-2-méthyl-1-phenyl-propan-1-one, 2,4,6-triméthylbenzoyl-diphenyl-phosphine oxyde, 2,4,6-trimethylbenzoylphenyl phosphinate, 1-hydroxy-cyclohexyl-phenyl-cétone, bis(2,6-diméthoxybenzoyl)-2,4,4-triméthyl-pentyl phosphine oxyde, 1-[4-(2-hydroxyéthoxy)-phenyl]-2-hydroxy-2-méthyl-1-propane-1-one, 2,2-diméthoxy-1,2-diphenyléthan-1-one, le 2-méthyl-1[4-(méthylthio)phenyl]-2-morpholinopropan-1-one, 2,4-diethylthioxanthone, leurs dérivés, et mélanges de ceux-ci.

Les constituants précités sont véhiculés dans un solvant organique polaire qui peut être choisi, de manière non limitative, parmi les esters tels que l'acétate d'éthyle, l'acétate de propyle, l'acétate de butyle, le propionate d'isobutyle, le propylène glycol monométhyl éther, le lactate de méthyle, le lactate d'éthyle et la gamma-butyrolactone ; les alkyl phosphates tels que le triéthylphosphate ; les alkyl carbonates tels que le diméthyl carbonate ; les cétones telles que l'acétone, l'acétylacétone, la méthyl isobutyl cétone, la 2-butanone, la 2-pentanone, la 2-heptanone, la 3-heptanone, la cyclopentanone et la cyclohexanone ; les amides tels que le diméthyl formamide (DMF) ou le diméthylacétamide (DMAc) ; les solvants soufrés tels que le diméthylsulfoxyde (DMSO) ; les solvants halogénés tels que le chloroforme, et les alcanes halogénés ; et leurs mélanges. On préfère dans cette invention utiliser la 2-butanone, la cyclohexanone, le diméthylsulfoxyde, le propylène glycol monométhyl éther, le triéthylphosphate, le diméthylacétamide, et leurs mélanges.

Une fois l'encre obtenue à partir des constituants décrits précédemment, elle est appliquée sous forme de film sur un substrat qui peut être de nature quelconque et notamment constitué d'une ou plusieurs couches de verre ou métalliques ou organiques (notamment polymériques). Le copolymère utilisé selon l'invention possède en effet des propriétés mécaniques suffisantes pour lui permettre de pouvoir être mis en forme de film. Cette mise en forme de film peut se faire par exemple : par coulée de l'encre ; par dépôt par centrifugation de l'encre ; par immersion dans l'encre ; ou par impression de l'encre, notamment par jet d'encre ou sérigraphie. Les films ainsi obtenus, après une étape de séchage puis éventuellement une étape de recuit (notamment à une température de 70 à 140°C), possèdent de bonnes propriétés mécaniques et peuvent si nécessaire être étirés. Leur épaisseur peut par exemple être comprise entre 10 nm et 100 µm, de préférence entre 50 nm et 50 µm et plus préférentiellement entre 100 nm et 10 µm.

Avant cette étape de formation de film, il est possible d'ajouter divers additifs à l'encre réticulable, tels que des charges de renfort, des charges conductrices telles que des nanotubes de carbone, des sels conducteurs, des particules piézoélectriques telles que des nanoparticules de piezo-, ferro- ou pyroélectriques, telle que les céramiques PZT ou le BaTiO₃, des plastifiants, des promoteurs d'adhésion et leurs mélanges.

Il est également possible d'ajouter à l'encre, après réaction de la triéthylamine avec le copolymère selon l'invention, un ou plusieurs autres copolymères selon l'invention, identiques à, ou différents de, celui mis à réagir avec la triéthylamine. Dans ce cas, on veillera généralement à ce que ce copolymère additionnel représente au plus 60% en poids par rapport au poids total de copolymères selon l'invention (modifiés et non modifiés) présents dans l'encre.

Le film obtenu est ensuite soumis à une irradiation UV, généralement à une température de 15 à 40°C, par exemple de 20 à 30°C, afin de parfaire la réticulation du copolymère. Il est possible d'utiliser à cette fin toute technique connue de l'homme de l'art et notamment une irradiation par lampe à arc à vapeur de mercure. Après cette étape d'irradiation UV, le film peut éventuellement être soumis à une étape de post-traitement thermique à une température allant par exemple de 70 à 140°C.

Les copolymères réticulés obtenus selon l'invention présentent un caractère semicristallin.

Leur température de fusion est généralement comprise entre 100 et 160°C, plus particulièrement entre 105 et 155°C, par exemple entre 110 et 130°C. La température de fusion est mesurée par calorimétrie différentielle à balayage (DSC) sur un échantillon de polymère de 5 à 20 mg. Cette technique consiste à mesurer les différences des échanges de chaleur entre l'échantillon à analyser et une référence. Elle permet de déterminer les transitions de phase, dont notamment la température de fusion, et les enthalpies correspondant à ces phénomènes. Pour les copolymères de l'invention, la gamme de température balayée est de -20 °C à 200 °C, à une vitesse de 10°C par minute. On réalise au moins 2 cycles (2 chauffages et 2 refroidissements). La température de fusion est par convention la valeur au maximum du pic de fusion. Ces copolymères satisfont en outre à au moins un critère qui les qualifie comme des polymères électroactifs, en particulier ils présentent une température de Curie inférieure à leur point de fusion, par exemple comprise entre 20 et 145°C, et un maximum de constante diélectrique supérieur à 30.

Ces copolymères présentent avantageusement un champ coercitif inférieur à 60 MV/m, une permittivité électrique supérieure à 10, voire supérieure à 20 ou même supérieure ou égale à 30, à 25°C et 1 kHz et/ou une polarisation à saturation supérieure à 30 mC/m², par exemple supérieure à 40 mC/m², voire supérieure à 50 mC/m² ou même supérieure à 60 mC/m².

En outre, du fait de leur réticulation, ces copolymères présentent en outre une résistance aux solvants tels que ceux listés précédemment, se traduisant par une perte de moins de 20% de la masse du film obtenu selon l'invention, après immersion pendant cinq minutes à température ambiante dans ces solvants. Il est ainsi possible de mettre ce film en oeuvre dans un procédé de photolithographie, dans lequel l'étape d'irradiation aux UV décrite précédemment est conduite en présence d'un masque, de manière à réticuler certaines parties du film seulement, après quoi les zones non réticulées peuvent être sélectivement éliminées à l'aide d'un solvant dans l'étape de développement.

Les films obtenus selon l'invention sont utiles pour la fabrication de dispositifs (opto)électroniques, y compris des transistors à films fins, des transistors lumineux, des transistors à effet de champ et des condensateurs ; de dispositifs haptiques ; d'actionneurs ; de microsystèmes électromécaniques (MEMS) ; de capteurs ; de cathéters orientables ; de claviers braille ; de dispositifs acoustiques (hauts parleurs ou « tweeters ») ; de dispositifs électrocaloriques ; de dispositifs de récupération d'énergie, par exemple. On préfère utiliser ces films dans des transistors. Dans le domaine de l'électronique organique imprimée, le film selon l'invention selon l'invention peut en particulier être utilisé pour la fabrication de la couche diélectrique de grille d'un transistor à effet de champ.

En raison des propriétés précitées du copolymère réticulé formant les films selon l'invention, ceux-ci peuvent présenter des caractéristiques avantageuses dans les applications ci-dessus et notamment de faibles densités de courant de fuite, des tensions de claquage élevées, des valeurs de capacitance élevées, de faibles tensions de fonctionnement (typiquement inférieures à 40V, voire à 30V ou à 20V) et/ou une faible hystérésis.

### EXEMPLES

Les exemples ci-dessous sont donnés à des purement illustratives et n'ont pas pour but de limiter la portée de cette invention qui est définie par les revendications annexées.

### A) Préparation de copolymères fluorés

### Exemple préparatif 1 : synthèse d'un terpolymère P(VDF-TrFE-CTFE) (P1)

Le terpolymère P(VDF-TrFE-CTFE) est préparé par polymérisation en suspension dans l'eau. Dans un réacteur de 3 L désaéré et sous vide, on introduit, à température ambiante, 2,28 kg d'eau déminéralisée, 208 g de TrFE, 302 g de VDF puis un stabilisant de type hydroxypropylméthyl cellulose. Le réacteur est chauffé jusqu'à 48 °C puis un amorceur radicalaire de type peroxydicarbonate en solution dans un agent de transfert est ajouté. La pression dans le réacteur est comprise entre 80 et 100 bars. Cette pression est maintenue constante durant la polymérisation par injection d'un mélange de VDF/TrFE/CTFE de composition molaire 57/31/12. Après injection de 612 g du mélange secondaire, l'injection est arrêtée et le réacteur refroidi à température ambiante. La suspension est ensuite lavée à l'eau déminéralisée pendant 24 h à 50 °C puis séchée 24 h à 60 °C sous balayage d'azote.

La composition molaire finale du terpolymère déterminée par spectroscopie RMN ¹H et ¹⁹F du liquide est de 62/30/8 avec un MFI à 203 °C sous 10 kg de 1,90 et une température de fusion déterminée par DSC lors de la deuxième chauffe de 122,6 °C.

### Exemple préparatif 2 : Préparation d'un terpolymère modifié par la TEA (P2)

Dans un ballon monocol de 250 mL surmonté d'un réfrigérant à eau, 5,02 g de terpolymère P1 contenant 8 mol% de CTFE et 2,18 g de triethylamine (TEA) sont mélangés dans 100 g de diméthylsulfoxyde (DMSO). Le milieu réactionnel est chauffé pendant 4 h à 50 °C sous agitation magnétique.

Le produit est purifié par précipitation dans l'eau, puis reprécipitation dans un mélange massique 50/50 méthanol/eau. La poudre de terpolymère P(VDF-TrFE-CTFE) modifiée est ensuite lavée au méthanol puis séchée sous vide à 50 °C pendant 8 h. Le rendement de la réaction est de 90 % et le produit final est caractérisé par spectroscopie infra-rouge et calorimétrie différentielle à balayage.

### Exemple préparatif 3 : Préparation d'un terpolymère comparatif modifié par la NN-DMBA (P3)

Dans un ballon monocol de 250 mL surmonté d'un réfrigérant à eau, 5,03 g de terpolymère P1 contenant 8 mol% de CTFE et 2,94 g de NN-dimethylbenzilamine (NN-DMBA) sont mélangés dans 100 g de diméthylsulfoxyde (DMSO). Le milieu réactionnel est chauffé pendant 4 h à 50 °C sous agitation magnétique.

Le produit est purifié par précipitation dans l'eau, puis reprécipitation dans un mélange massique 50/50 méthanol/eau. La poudre de terpolymère P(VDF-TrFE-CTFE) modifiée est ensuite lavée au méthanol puis séchée sous vide à 50 °C pendant 8 h. Le rendement de la réaction est de 89 % et le produit final est caractérisé par spectroscopie infra-rouge.

### B) Caractérisation des terpolymères

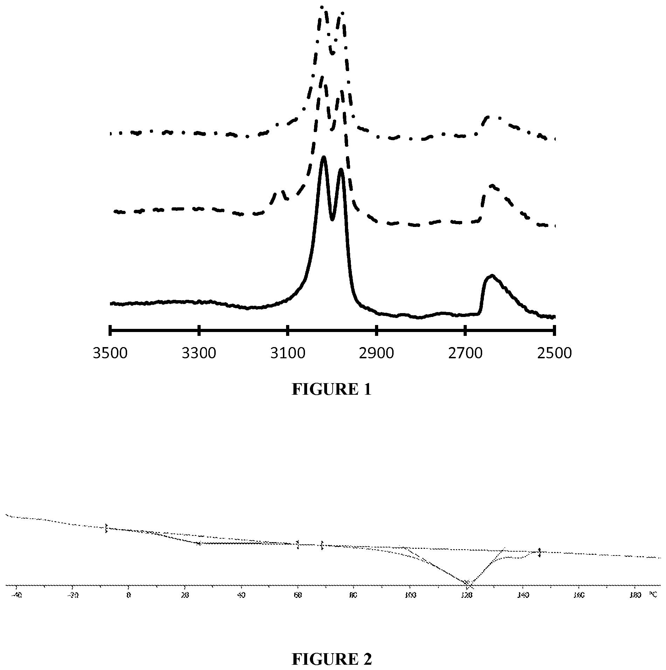

Comme le montre la Figure 1, qui représente le spectre FTIR des produits P1 à P3, on observe à 3120 cm⁻¹ les bandes de vibration de valence caractéristiques des liaisons C-H d'une double liaison -CH=CF-. Ce signal est plus intense pour le terpolymère modifié avec la TEA (P2). Avec des conditions réactionnelles identiques, la TEA permet donc une meilleure modification chimique que la NN-DMBA (P3).

En outre, comme le montre la Figure 2, la modification du terpolymère P1 par la TEA (P2) ne modifie pas de manière important la structure semi-cristalline du matériau. La présence d'un premier pic endothermique à 25 °C est caractéristique du comportement relaxeur-ferroélectrique du terpolymère modifié par la TEA.

### C) Préparation d'encres contenant des terpolymères

### Exemple 1 : Formulation d'une encre contenant un terpolymère et de la TEA (E1)

Dans un ballon monocol de 250 mL surmonté d'un réfrigérant à eau, 5,0 g de terpolymère P1 contenant 8 mol% de CTFE, 50 mg de 6-trimethylbenzoylphenyl phosphinate (TPO-L), 25 mg de 2,4-Diethylthioxanthone (DETX) et 2,0 g de triéthylamine (TEA) sont mélangés dans 100,0 g de butane-2-one (MEK). La solution est chauffée pendant 4 h à 80 °C sous agitation magnétique.

La solution est laissée au repos sans agitation pour refroidir à température ambiante pendant au minimum 4 h puis filtrée sur un filtre en polypropylène ayant une porosité de 1 µm.

### Exemple 2 : Formulation d'une encre contenant un terpolymère modifié préalablement par la TEA (S1 à S4)

Dans un flacon brun de 50 mL, 1,50 g de terpolymère modifié P2 est dissous dans 20,0 g de propylène glycol méthyl éther acétate (PGMEA). La solution est agitée par un barreau magnétique à température ambiante pendant 4 h.

Dans un second flacon brun, 0,504 g de 6-trimethylbenzoylphenyl phosphinate (TPO-L) et 0,252 g de 2,4-diéthylthioxanthone (DETX) sont dissous dans 10,0 g de PGMEA). La solution est agitée par un barreau magnétique à température ambiante pendant 4 h.

Dans un tube à hémolyse de 4 mL, 42 mg d'un co-agent de réticulation (composé polyacrylate ou polythiol), 100 mg de solution de photo-amorceur et 3,0 g de la solution de terpolymère modifié sont mélangés par agitation manuelle.

Agents réticulants utilisés :
**S1.** Aucun
**S2.** SR499 (triacrylate de triméthylopropane éthoxylé).
**S3.** SR351 (triacrylate de triméthylolpropane).
**S4.** Polythiol (tris(3-mercaptopropionate) de triméthylolpropane).

### Exemple 3 : Formulation d'une solution avec un co-agent en une seule étape (S5)

Dans un flacon brun de 50 mL, 1,50 g de terpolymère P1, 0,65 g de TEA, 100 mg de solution de photo-amorceur sont mélangés dans 20,0 g de propylène glycol méthyl éther acétate (PGMEA). La solution est agitée par un barreau magnétique à 50 °C pendant 4 h puis 0,30 g du co-agent de réticulation SR499 (ethoxylated triacrylate de triméthylopropane éthoxylé) sont ajoutés.

### D) Evaluation des propriétés des polymères fluorés et encres

### 1) Electroactivité

L'électro-activité des terpolymères P1 et P2 préparés à l'Exemple A est évaluée par polarisation d'un film de 20 µm donnant accès aux valeurs de champ coercitif (Ec), de polarisation rémanente (Pᵣ), et de polarisation à saturation (Pₛₐₜ). Un champ électrique alternatif d'amplitude croissante et d'une fréquence 50 mHz est appliqué par le biais des électrodes sur une surface de 1 mm² du film. On mesure le courant qui traverse l'échantillon en fonction du champ électrique appliqué via un ampèremètre de précision.

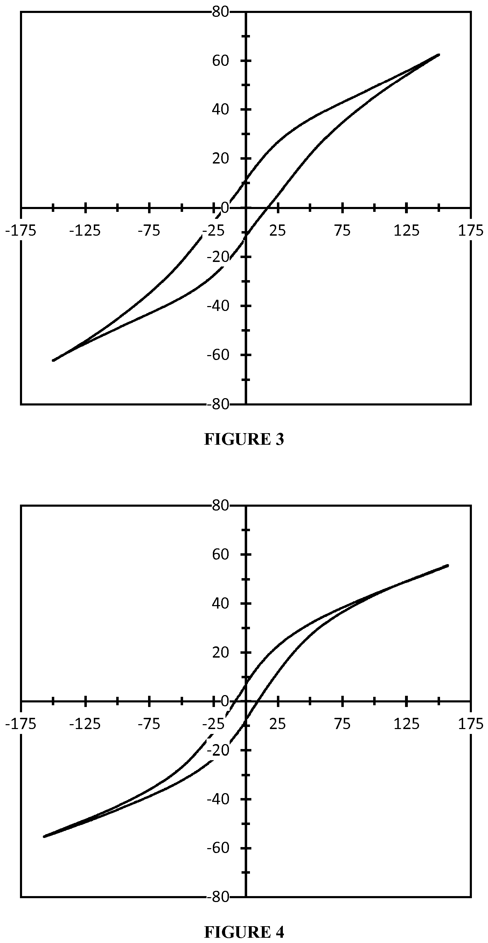

Les résultats de cette mesure sont illustrés sur les Figures 3 et 4.

Comme il ressort de ces Figures, on observe une diminution du champ coercitif après modification chimique (de 17 à 8 MV/m) indiquant un meilleur comportement relaxeur ferroélectrique du terpolymère P2 par rapport à P1. La polarisation à saturation est toujours très supérieure à 30 mC.m⁻² avec une Pₛₐₜ = 62,4 et 55,3 mC. m⁻², pour P2 et P1, respectivement.

### 2) Permittivité

On a par ailleurs mesuré la permittivité des copolymères P1 à P3. qui est rapportée dans le tableau 1 ci-dessous :

**Tableau 1**

| **Exemple** | **Permittivité Relative à25 °C et 1 kHz** |
|---|---|
| P1 | 30 |
| P2 | 33 |
| P3 | 30 |

Comme le montre ce Tableau, la permittivité du terpolymère P1 est de 30, donc bien supérieure à celle des copolymères P(VDF-TrFE) qui est en général d'environ 10, du fait de la présence du CTFE. On pourrait penser qu'une réaction chimique faisant disparaitre le chlore du CTFE pourrait diminuer la permittivité du produit final. On observe ici au contraire que le terpolymère modifié par la TEA (P2) possède une permittivité légèrement supérieure au terpolymère initial (P1) malgré la réaction de déshydrochloration.Tel n'est pas le cas du terpolymère modifié par la NN-DMBA (P3).

### 3) Résistance aux solvants

On a évalué la résistance aux solvants du terpolymère P1 non modifié, par comparaison avec :
- le terpolymère formulé en présence de TEA (E1), en l'absence ou en présence d'agent réticulant (E1 et S5), et
- le même terpolymère modifié par la TEA et formulé en l'absence ou en présence de différents réticulants (S1, S2, S3 et S4).

Pour ce faire, des films sur des plaques en verre sont réalisés à partir des formulations E1, S1, S2, S3, S4, S5 préparées dans les exemples C1 à C3, par dépôt à la tournette (10 sec à 500 tr/min avec une Acc = 500 tr/min puis 30 sec à 1000 tr/min avec une Acc = 500 tr/min).

Le dépôt est séché sur une plaque chauffante à 100 °C pendant 1 minute puis irradié par une lampe UV LED à 405 nm pendant 15 secondes. Après irradiation, le film subit une étape de post-traitement thermique à 100 °C pendant 5 minutes.

La réticulation des films est évaluée par un test de résistance au PGMEA.

Les résultats de cet essai sont présentés dans le Tableau 2 ci-dessous où 0 correspond à aucune résistance au solvant (100 % de perte de masse) et 5 correspond à moins de 20 % de perte de masse.

**Tableau 2**

| **Produit** | **Résistance au solvant** |
|---|---|
| P1 | 0 |
| E1 | 1 |
| S1 | 1 |
| 52 | 5 |
| S3 | 5 |
| 54 | 4 |
| 55 | 5 |

Comme le démontrent ces résultats, la résistance aux solvants du terpolymère P1 non modifié est nulle, et est légèrement améliorée après modification par la TEA suivant deux procédés différents (E1 et S1). L'ajout de co-agents de réticulation permet d'apporter une meilleure résistance au PGMEA (S2 à S5).

## Revendications

1. Procédé de préparation d'un film de polymère fluoré réticulé, comprenant les étapes successives de :
(1) formulation d'une encre contenant, de préférence constituée par : (a) le produit de la réaction de la triéthylamine avec au moins un copolymère fluoré obtenu par copolymérisation radicalaire de monomères comprenant, et de préférence constitués par : (i) le fluorure de vinylidène (VDF), (ii) le trifluoroéthylène (TrFE), (iii) au moins un monomère chloré de formule -CXCl=CX₁X₂ où X, X₁ et X₂ désignent indépendamment H, F ou CF₃, étant entendu qu'au plus l'un de X, X₁ et X₂ désigne CF₃ ; (b) au moins un agent réticulant ; (c) au moins un photo-amorceur ; et (d) au moins un solvant organique ;
(2) l'application de ladite encre sous forme de film sur un substrat ; et
(3) l'irradiation UV dudit film.

2. Procédé selon la revendication 1, **caractérisé en ce que** le monomère chloré est le chlorotrifluoroéthylène (CTFE) ou le chlorofluoroéthylène (CFE).

3. Procédé selon la revendication 1 ou 2, **caractérisé en ce que** la proportion de motifs issus du TrFE va de 5 à 95 mol.% et de préférence de 15 à 55 mol.%, par rapport à la somme des motifs issus du VDF et du TrFE.

4. Procédé selon l'une quelconque des revendications 1 à 3, **caractérisé en ce que** la proportion de motifs issus du monomère chloré varie de 1 à 20 mol.%, en particulier de 5 à 15 mol.%, par rapport à la totalité des motifs.

5. Procédé selon l'une quelconque des revendications 1 à 4, **caractérisé en ce que** les motifs issus du monomère additionnel éventuellement présent représentent de 0 à 20 mol.% et de préférence de 5 à 15 mol.%, par rapport à la totalité des motifs.

6. Procédé selon l'une quelconque des revendications 1 à 3, **caractérisé en ce que** l'agent réticulant est choisi parmi les monomères ou oligomères portant au moins deux fonctions (méth)acryliques réactives en polymérisation radicalaire, qui peuvent éventuellement comprendre en outre au moins une autre fonction choisie parmi des fonctions hydroxyles, esters, éthers, uréthanes, époxy, cyanurates ou iso-cyanurates.

7. Procédé selon l'une quelconque des revendications 1 à 6, **caractérisé en ce que** le solvant organique polaire est choisi parmi : les esters tels que l'acétate d'éthyle, l'acétate de propyle, l'acétate de butyle, le propionate d'isobutyle, le propylène glycol monométhyl éther, le lactate de méthyle, le lactate d'éthyle et la gamma-butyrolactone ; les alkyl phosphates tels que le triéthylphosphate ; les alkyl carbonates tels que le diméthyl carbonate ; les cétones telles que l'acétone, l'acétylacétone, la méthyl isobutyl cétone, la 2-butanone, la 2-pentanone, la 2-heptanone, la 3-heptanone, la cyclopentanone et la cyclohexanone ; les amides tels que le diméthyl formamide (DMF) ou le diméthylacétamide (DMAc) ; les solvants soufrés tels que le diméthylsulfoxyde (DMSO) ; les solvants halogénés tels que le chloroforme, et les alcanes halogénés ; et leurs mélanges, de préférence la 2-butanone, la cyclohexanone, le diméthylsulfoxyde, le propylène glycol monométhyl éther, le triéthylphosphate, le diméthylacétamide, et leurs mélanges .

8. Film de polymère fluoré réticulé susceptible d'être obtenu suivant le procédé selon l'une quelconque des revendications 1 à 7.

9. Utilisation du film selon la revendication 8 pour la fabrication de dispositifs (opto)électroniques, y compris des transistors à films fins, des transistors lumineux, des transistors à effet de champ et des condensateurs ; de dispositifs haptiques ; d'actionneurs ; de microsystèmes électromécaniques (MEMS) ; de capteurs ; de cathéters orientables ; de claviers braille ; de dispositifs acoustiques (hauts parleurs ou « tweeters ») ; de dispositifs électrocaloriques ; de dispositifs de récupération d'énergie, de préférence dans la fabrication de transistors.

10. Utilisation du film selon la revendication 8 en tant que couche diélectrique de grille dans un transistor à effet de champ.

## Patentansprüche

1. Verfahren zur Herstellung einer Dünnschicht aus vernetztem Fluorpolymer, das nacheinander die folgenden Schritte umfasst:
(1) Formulieren einer Druckfarbe, die Folgendes enthält, wobei sie vorzugsweise daraus besteht: (a) das Produkt einer Reaktion von Triethylamin mit mindestens einem fluorierten Copolymer, das mittels radikalischer Copolymerisation von Monomeren erhalten wurde, welche Folgendes umfassen, wobei sie vorzugsweise daraus bestehen: (i) Vinylidenfluorid (VDF), (ii) Trifluorethylen (TrFE), (iii) mindestens ein chloriertes Monomer der Formel -CXCl=CX₁X₂, wobei X, X₁ und X₂ unabhängig voneinander für H, F oder CF₃ stehen, wobei es sich versteht, dass höchstens eines von X, X₁ und X₂ für CF₃ steht; (b) mindestens ein Vernetzungsmittel; (c) mindestens einen Photoinitiator; und (d) mindestens ein organisches Lösungsmittel;
(2) Aufbringen der Druckfarbe in Form einer Dünnschicht auf ein Substrat; und
(3) UV-Bestrahlen der Dünnschicht.

2. Verfahren nach Anspruch 1, **dadurch gekennzeichnet, dass** es sich bei dem chlorierten Monomer um Chlortrifluorethylen (CTFE) oder Chlorfluorethylen (CFE) handelt.

3. Verfahren nach Anspruch 1 oder 2, **dadurch gekennzeichnet, dass** der Anteil an Bausteinen, die aus TrFE hervorgehen, im Bereich von 5 bis 95 mol.-% und vorzugsweise von 15 bis 55 mol.-% liegt, bezogen auf die Summe der Bausteine, welche aus VDF und TrFE hervorgehen.

4. Verfahren nach einem beliebigen der Ansprüche 1 bis 3, **dadurch gekennzeichnet, dass** der Anteil an Bausteinen, die aus dem chlorierten Monomer hervorgehen, von 1 bis 20 mol.-%, insbesondere von 5 bis 15 mol.-% variiert, bezogen auf die Gesamtheit der Bausteine.

5. Verfahren nach einem beliebigen der Ansprüche 1 bis 4, **dadurch gekennzeichnet, dass** die Bausteine, welche aus dem möglicherweise vorhandenen zusätzlichen Monomer hervorgehen, 0 bis 20 mol.-% und vorzugsweise 5 bis 15 mol.-% ausmachen, bezogen auf die Gesamtheit der Bausteine.

6. Verfahren nach einem beliebigen der Ansprüche 1 bis 3, **dadurch gekennzeichnet, dass** das Vernetzungsmittel aus den Monomeren oder Oligomeren ausgewählt ist, die mit mindestens zwei funktionellen (Meth)acrylgruppen versehen sind, welche zur Reaktion mittels radikalischer Polymerisation befähigt sind, wobei sie darüber hinaus möglicherweise mindestens eine weitere funktionelle Gruppe umfassen können, die aus den funktionellen Gruppen Hydroxyl, Ester, Ether, Urethan, Epoxy, Cyanurat oder Isocyanurat ausgewählt ist.

7. Verfahren nach einem beliebigen der Ansprüche 1 bis 6, **dadurch gekennzeichnet, dass** das polare organische Lösungsmittel aus den folgenden ausgewählt ist: den Estern wie etwa Ethylacetat, Propylacetat, Butylacetat, Isobutylpropionat, Propylenglykolmonomethylether, Methyllactat, Ethyllactat und gamma-Butyrolacton; den Alkylphosphaten wie etwa Triethylphosphat; den Alkylcarbonaten wie etwa Dimethylcarbonat; den Ketonen wie etwa Aceton, Acetylaceton, Methylisobutylketon, 2-Butanon, 2-Pentanon, 2-Heptanon, 3-Heptanon, Cyclopentanon und Cyclohexanon; den Amiden wie etwa Dimethylformamid (DMF) oder Dimethylacetamid (DMAc); den schwefelhaltigen Lösungsmitteln wie etwa Dimethylsulfoxid (DMSO); den halogenhaltigen Lösungsmitteln wie etwa Chloroform und den halogenierten Alkanen; und deren Mischungen, wobei es sich vorzugsweise um 2-Butanon, Cyclohexanon, Dimethylsulfoxid, Propylenglykolmonomethylether, le Triethylphosphat, Dimethylacetamid und deren Mischungen handelt.

8. Dünnschicht aus vernetztem Fluorpolymer, die gemäß dem Verfahrens nach einem beliebigen der Ansprüche 1 bis 7 erhalten werden kann.

9. Verwendung der Dünnschicht nach Anspruch 8 zur Herstellung von (opto)elektronischen Vorrichtungen, wobei dazu Dünnschichttransistoren, Fototransistoren, Feldeffekttransistoren und Kondensatoren gehören; von haptischen Vorrichtungen; von Stellorganen; von elektromechanischen Mikrosystemen (MEMS); von Sensoren; von ausrichtbaren Kathetern; von Braille-Tastaturen; von akustischen Vorrichtungen (Lautsprechern oder Kalottenhochtönern); von elektrokalorischen Vorrichtungen; von Energierückgewinnungsvorrichtungen, vorzugsweise in der Herstellung von Transistoren.

10. Verwendung der Dünnschicht nach Anspruch 8 als dielektrische Gateschicht in einem Feldeffekttransistor.

## Claims

1. Process for preparing a crosslinked fluoropolymer film, comprising the successive steps of:
(1) formulating an ink containing, preferably consisting of: (a) the product of the reaction of triethylamine with at least one fluorinated copolymer obtained by radical copolymerization of monomers comprising, and preferably consisting of: (i) vinylidene fluoride (VDF), (ii) trifluoroethylene (TrFE), (iii) at least one chlorinated monomer of formula -CXCl=CX₁X₂ where X, X₁ and X₂ independently denote H, F or CF₃, it being understood that at most one of X, X₁ and X₂ denotes CF₃; (b) at least one crosslinking agent; (c) at least one photoinitiator; and (d) at least one organic solvent;
(2) applying said ink in film form to a substrate; and
(3) UV-irradiating said film.

2. Process according to Claim 1, **characterized in that** the chlorinated monomer is chlorotrifluoroethylene (CTFE) or chlorofluoroethylene (CFE).

3. Process according to Claim 1 or 2, **characterized in that** the proportion of units derived from TrFE ranges from 5 to 95 mol% and preferably from 15 to 55 mol%, relative to the sum of the units derived from VDF and TrFE.

4. Process according to any one of Claims 1 to 3, **characterized in that** the proportion of units derived from the chlorinated monomer varies from 1 to 20 mol%, in particular from 5 to 15 mol%, relative to all of the units.

5. Process according to any one of Claims 1 to 4, **characterized in that** the units derived from the additional monomer optionally present represent from 0 to 20 mol% and preferably from 5 to 15 mol%, relative to all of the units.

6. Process according to any one of Claims 1 to 3, **characterized in that** the crosslinking agent is chosen from monomers or oligomers bearing at least two (meth)acrylic functions that are reactive in radical polymerization, which may optionally further comprise at least one other function chosen from hydroxyl, ester, ether, urethane, epoxy, cyanurate or isocyanurate functions.

7. Process according to any one of Claims 1 to 6, **characterized in that** the polar organic solvent is chosen from: esters such as ethyl acetate, propyl acetate, butyl acetate, isobutyl propionate, propylene glycol monomethyl ether, methyl lactate, ethyl lactate and gamma-butyrolactone; alkyl phosphates such as triethyl phosphate; alkyl carbonates such as dimethyl carbonate; ketones such as acetone, acetylacetone, methyl isobutyl ketone, 2-butanone, 2-pentanone, 2-heptanone, 3-heptanone, cyclopentanone and cyclohexanone; amides such as dimethylformamide (DMF) or dimethylacetamide (DMAc); sulfur-containing solvents such as dimethyl sulfoxide (DMSO); halogenated solvents such as chloroform, and halogenated alkanes; and mixtures thereof, preferably 2-butanone, cyclohexanone, dimethyl sulfoxide, propylene glycol monomethyl ether, triethyl phosphate, dimethylacetamide, and mixtures thereof.

8. Crosslinked fluoropolymer film capable of being obtained according to the process according to any one of Claims 1 to 7.

9. Use of the film according to Claim 8, for the manufacture of (opto)electronic devices, including thinfilm transistors, light transistors, field-effect transistors and capacitors; haptic devices; actuators; microelectromechanical systems (MEMS); sensors; steerable catheters; Braille keyboards; acoustic devices (loudspeakers or "tweeters"); electrocaloric devices; energy recovery devices, preferably in the manufacture of transistors.

10. Use of the film according to Claim 8 as a gate dielectric layer in a field-effect transistor.
